# EUROPÄISCHE PATENTANMELDUNG

(11) **EP 1 278 138 A2**
(43) Veröffentlichungstag der Anmeldung: **22.01.2003**
(21) Anmeldenummer: 02015843.2
(22) Anmeldetag: 16.07.2002
(51) Int. Cl.: G06F 17/50

(54) **Verfahren, durch welches basierend auf dem Schaltplan einer digitalen Schaltung der im Betrieb der digitalen Schaltung von dieser gezogene Strom ermittelbar ist**

(30) Priorität: 19.07.2001 DE 10135284
(71) Anmelder: Infineon Technologies AG, 81669 München (DE)
(72) Erfinder: Steinecke, Thomas, 85457 Wörth (DE)
(74) Vertreter: Repkow, Ines, Dr. Dipl.-Ing.

(57) **Zusammenfassung**

Das beschriebene Verfahren zeichnet sich dadurch aus, daß die Ermittlung des Stromes unter Verwendung einer Ersatzschaltung erfolgt, in welcher Schaltungsteile der digitalen Schaltung, deren Ausgangssignalpegel sich gleichzeitig ändern oder ändern können, durch einen Inverter ersetzt sind. Dadurch läßt sich der von einer digitalen Schaltung gezogene Strom bereits beim Entwurf derselben einfach, schnell und genau ermitteln.

## Beschreibung

Die vorliegende Erfindung betrifft ein Verfahren gemäß dem Oberbegriff des Patentanspruchs 1, d.h. ein Verfahren, durch welches basierend auf dem Schaltplan einer digitalen Schaltung der im Betrieb der digitalen Schaltung von dieser gezogene Strom ermittelbar ist.

Die Kenntnis des Stromes, insbesondere des maximalen Stromes, den eine digitale Schaltung zieht, wird benötigt, um die Maßnahmen festzulegen, durch welche sichergestellt werden kann, daß dieser Strom nicht andere Komponenten des die digitale Schaltung enthaltenden Systems stört.

Störungen durch Ströme können auftreten, wenn diese so groß sind, daß sie zu Schwankungen der Versorgungsspannung führen. Solche Schwankungen können dazu führen, daß die digitale Schaltung selbst und/oder über die selbe Stromquelle oder die selben Versorgungsleitungen mit Energie versorgte Komponenten des die digitale Schaltung enthaltenden Systems nicht ordnungsgemäß arbeiten.

Wenn die digitale Schaltung Bestandteil einer integrierten Schaltung ist, bestehen die genannten Maßnahmen zur Verhinderung von Störungen beispielsweise darin, daß in die integrierte Schaltung Filter integriert werden, durch welche verhindert wird, daß der von der digitalen Schaltung gezogene Strom zu Schwankungen der Versorgungsspannung führt, durch welche die digitale Schaltung und/oder andere Komponenten des die digitale Schaltung enthaltenden Systems mit Energie versorgt werden.

Die optimale Dimensionierung dieser Filter hängt von der Größe der fließenden Ströme, insbesondere von der Größe des maximalen Stromes ab.

Bislang erfolgt die Dimensionierung der Filter aufgrund von Erfahrungswerten. Dabei kommt es nicht selten vor, daß die Dimensionierung erheblich von der optimalen Dimensionierung abweicht. D.h., das Filter ist häufig erheblich überdimensioniert oder erheblich unterdimensioniert.

Wenn das Filter unterdimensioniert ist, werden die durch das Filter zu vermeidenden Versorgungsspannungs-Schwankungen nicht oder nicht ausreichend vermieden.

Wenn das Filter überdimensioniert ist, wird die integrierte Schaltung, genauer gesagt der diese tragende Halbleiter-Chip größer als es notwendig ist. Die wesentlichen Bestandteile des Filters sind nämlich ein oder mehrere Kondensatoren, und deren Realisierung in einer integrierten Schaltung erfordert relativ viel Chipfläche. Je größer die integrierte Schaltung wird, desto teurer wird sie auch, wobei wegen der großen Stückzahlen, in welchen integrierte Schaltungen hergestellt werden, selbst geringfügige Verteuerungen erhebliche Mehrkosten verursachen.

Daher muß dann, wenn sich nach der Herstellung einer integrierten Schaltung herausstellt, daß das Filter überdimensioniert oder unterdimensioniert ist, häufig eine verbesserte (eine einen richtig dimensionierten Filter aufweisende) integrierte Schaltung entworfen werden.

Dies ist mit einem hohen Aufwand und hohen Kosten verbunden.

Es wäre daher sehr vorteilhaft, wenn es Möglichkeiten gäbe, das Filter schon beim Entwurf der digitalen Schaltung richtig zu dimensionieren. Eine solche Möglichkeit existiert aber nur für relativ einfach aufgebaute digitale Schaltungen. Solche Schaltungen können unter Verwendung deren backannotierter Netzliste simuliert werden. Die Netzliste gibt den Schaltplan der zu realisierenden digitalen Schaltung wieder. Sie enthält eine Liste der Bauteile, die die betreffende Schaltung enthält, und deren Verschaltung. Diese Netzliste wird zur Erstellung des Layouts der die betreffende digitale Schaltung enthaltenden integrierten Schaltung verwendet. Die backannotierte Netzliste enthält darüber hinaus Informationen über vorhandene parasitäre Kapazitäten, Induktivitäten und Widerstände, mit welchen bei der praktischen Realisierung der zugrundeliegenden digitalen Schaltung zu rechnen ist. Basierend auf der backannotierten Netzliste kann detailliert ermittelt werden, wie sich die digitale Schaltung während des Betriebes derselben verhalten wird. Dabei kann auch ermittelt werden, welche Ströme bei welchen Eingangssignalen fließen.

Bei komplexen digitalen Schaltungen wie beispielsweise Mikrocontrollern sind solche Simulationen aufgrund der großen Datenmengen, die zu verarbeiten sind, und der daraus resultierenden langen Rechenzeit des Simulationsrechners in der Praxis nicht möglich.

Der vorliegenden Erfindung liegt daher die Aufgabe zugrunde, eine Möglichkeit zu finden, durch welche sich der von einer digitalen Schaltung gezogene Strom bereits beim Entwurf derselben einfach, schnell und genau ermitteln läßt.

Diese Aufgabe wird erfindungsgemäß durch das in Patentanspruch 1 beanspruchte Verfahren gelöst.

Das erfindungsgemäße Verfahren zeichnet sich dadurch aus, daß die Ermittlung des Stromes unter Verwendung einer Ersatzschaltung erfolgt, in welcher Schaltungsteile der digitalen Schaltung, deren Ausgangssignalpegel sich gleichzeitig ändern oder ändern können, durch einen Inverter ersetzt sind.

Eine Ersatzschaltung, in welcher Schaltungsteile der digitalen Schaltung, deren Ausgangssignalpegel sich gleichzeitig ändern oder ändern können, durch einen Inverter ersetzt sind, weist einen erheblich einfacheren Aufbau auf als die durch die Ersatzschaltung ersetzte digitale Schaltung auf. Dieser einfache Aufbau der Ersatzschaltung ermöglicht es, daß der durch diese fließende Strom, und damit auch der durch die digitale Schaltung fließende Strom selbst mit herkömmlichen Methoden zur Ermittlung eines Stromes aus einem Schaltplan einfach, schnell und genau ermittelt werden kann.

Vorteilhafte Weiterbildungen der Erfindung sind den Unteransprüchen, der folgenden Beschreibung und den Figuren entnehmbar.

Die Erfindung wird nachfolgend anhand von Ausführungsbeispielen unter Bezugnahme auf die Figuren näher erläutert. Es zeigen
- Figur 1: eine digitale Schaltung, die bereits in durch Inverter ersetzbare Schaltungsteile ersetzt ist,
- Figur 2: eine zur Berechnung des Stromes, den die Schaltung gemäß Figur 1 im Betrieb zieht, verwendbare Ersatzschaltung,
- Figur 3: eine erste Möglichkeit zum Aufbau der in der Figur 2 gezeigten Ersatzinverter,
- Figur 4: eine zweite Möglichkeit zum Aufbau der in der Figur 2 gezeigten Ersatzinverter,
- Figur 5: eine weiter vereinfachte Ersatzschaltung, und
- Figur 6: als Eingangssignale für die Ersatzschaltung gemäß Figur 5 verwendete Signale.

Die digitale Schaltung, für welche basierend auf dem Schaltplan derselben der von dieser im praktischen Einsatz gezogene Strom ermittelt werden soll, ist im betrachteten Beispiel eine synchron getaktete digitale Schaltung, genauer gesagt ein Mikrocontroller oder ein Teil (ein bestimmtes Modul) eines Mikrocontrollers.

Es sei jedoch bereits an dieser Stelle darauf hingewiesen, daß das im folgenden beschriebene Verfahren prinzipiell auch bei beliebigen anderen digitalen Schaltungen zum Einsatz kommen kann.

Bei dem im folgenden beschriebenen Verfahren erfolgt die Ermittlung des Stromes, den eine digitale Schaltung im praktischen Einsatz zieht, unter Verwendung einer Ersatzschaltung, in welcher Schaltungsteile, die gleichzeitig ihren Ausgangssignalpegel ändern oder ändern können, durch einen Inverter ersetzt sind.

Dem liegt die Erkenntnis zugrunde, daß eine synchron getaktete digitale Schaltung auf eine Vielzahl von Inverterfunktionen, d.h. Schaltvorgänge vom logischen Pegel 0 auf den logischen Pegel 1 und umgekehrt reduziert werden kann.

Eine digitale Schaltung kann folglich durch eine Anzahl von im folgenden als Ersatzinverter bezeichneten Invertern beschrieben werden, von welchen ein Teil von 0 nach 1 schaltet, und der Rest von 1 nach 0.

Der Vollständigkeit halber sei bereits an dieser Stelle darauf hingewiesen, daß eine unter Verwendung von Ersatzinvertern aufgebaute Ersatzschaltung kein vollwertiger Ersatz für die digitale Schaltung darstellt, welche durch die Ersatzschaltung ersetzt wird. Insbesondere wird durch die Ersatzschaltung nicht die Funktion der durch die Ersatzschaltung ersetzten digitalen Schaltung nachgebildet. Die Ersatzschaltung eignet sich aber zur Ermittlung des im praktischen Einsatz der digitalen Schaltung von dieser gezogenen Stromes. Wie später noch genauer verstanden werden wird, erfolgt die Generierung der Ersatzschaltung teilweise basierend auf Schätzungen der in der digitalen Schaltung herrschenden Zustände und auftretenden Ereignisse, so daß der Strom, der unter Verwendung der Ersatzschaltung ermittelt wird, im allgemeinen nicht exakt dem tatsächlich fließenden Strom entsprechen wird. Die Abweichungen halten sich jedoch in Grenzen, so daß basierend auf dem ermittelten Strom eine hinreichend genaue Dimensionierung eines Versorgungsspannungsschwankungen verhindernden Filters durchgeführt werden kann.

Die Generierung der Ersatzschaltung kann mit Hilfe der Informationen erfolgen, die in der Netzliste für die digitale Schaltung enthalten sind. Dazu wird
- in einem ersten Schritt die digitale Schaltung in jeweils mehrere Bauteile (insbesondere in mehrere Transistoren, aber - sofern vorhanden - auch Widerstände, Kondensatoren, Spulen etc.) umfassende Schaltungsteile partitioniert,
- in einem zweiten Schritt ermittelt, welche der im ersten Schritt ermittelten Schaltungsteile gleichzeitig ihren Ausgangssignalpegel ändern oder ändern können,
- in einem dritten Schritt von den Schaltungsteilen, die gleichzeitig ihren Ausgangssignalpegel ändern oder ändern können, jeweils mehrere oder alle Schaltungsteile durch einen entsprechend großen einzigen Ersatzinverter ersetzt werden.

Die Schaltungsteile, in welche die digitale Schaltung im ersten Schritt partitioniert wird, sind Schaltungsteile mit einem oder mehreren Eingangsanschlüssen und einem oder mehreren Ausgangsanschlüssen. Im betrachteten Beispiel handelt es sich um Schaltungsteile, die logische Gatter wie beispielsweise UND-Gatter, ODER-Gatter, NAND-Gatter, NOR-Gatter, XOR-Gatter, Inverter etc. repräsentieren. Es sei jedoch bereits an dieser Stelle darauf hingewiesen, daß die genannten Schaltungsteile auch größere Schaltungsteile (beispielsweise mehrere Gatter repräsentierende Schaltungsteile) oder kleinere Schaltungsteile (beispielsweise nur einen Teil eines Gatters repräsentierende Schaltungsteile) sein können.

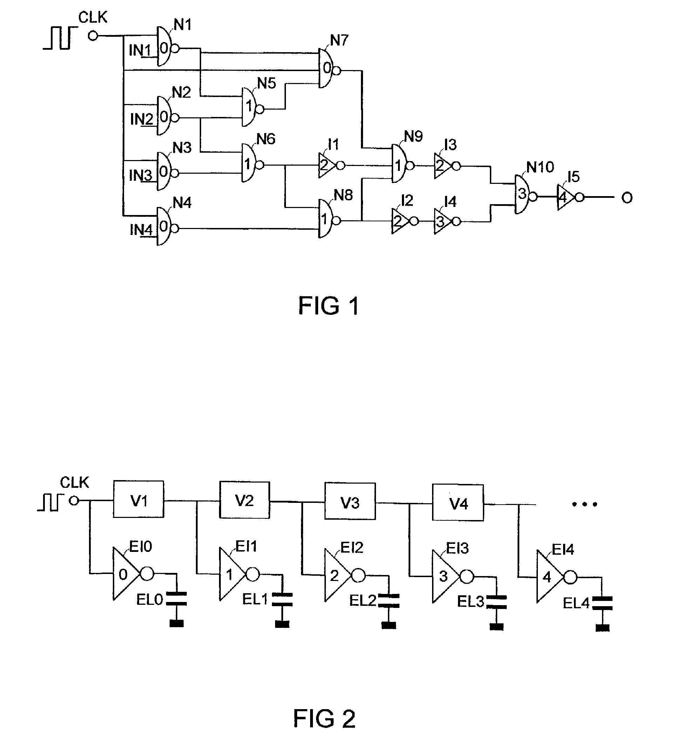

Sofern bereits ein die durch Ersatzinverter ersetzbaren Schaltungsteile enthaltender Schaltplan (beispielsweise ein Schaltplan nach Art des in der später beschriebenen Figur 1 gezeigten Schaltplanes) vorliegt, kann auf die Durchführung des ersten Schrittes selbstverständlich auch verzichtet werden.

Bei der im vorstehend erwähnten zweiten Schritt durchgeführten Ermittlung, welche der im ersten Schritt ermittelten Schaltungsteile gleichzeitig ihren Ausgangssignalpegel ändern oder ändern können, wird den betreffenden Schaltungsteilen ein im folgenden als logische Tiefe bezeichneter Wert zugeordnet. Die logische Tiefe gibt an, über wie viele hintereinander geschaltete Schaltungsteile ein jeweiliges Schaltungsteil mit einem Taktsignalanschluß der digitalen Schaltung verbunden ist, über welchen der digitalen Schaltung ein den zeitlichen Ablauf steuerndes Taktsignal zugeführt wird.

Im betrachteten Beispiel wird hierbei nur jeweils die kürzeste, genauer gesagt die am wenigsten andere Schaltungsteile enthaltende Verbindung zum Taktsignalanschluß berücksichtigt. Dabei wird bei mehrere Eingangsanschlüsse aufweisenden Schaltungsteilen nur der Eingangsanschluß berücksichtigt, dessen kürzeste Verbindung zum Taktsignalanschluß am kürzesten ist. Dies wird so gehandhabt, weil sich dadurch eine Worst-Case-Betrachtung anstellen läßt (kurz aufeinanderfolgende Schaltvorgänge verursachen größere Störungen als zeitlich länger auseinanderliegende Schaltvorgänge).

Es dürfte einleuchten, daß die logische Tiefe auch anders ermittelt werden kann. Insbesondere kann es sich unter Umständen als vorteilhaft erweisen, wenn die Ermittlung der logischen Tiefe
- unter Berücksichtigung der längsten Verbindung zum Taktsignalanschluß erfolgt, oder
- unter Berücksichtigung einer anderen als der kürzesten und der längsten Verbindung zum Taktsignalanschluß erfolgt, oder
- unter Berücksichtigung eines Mittelwertes erfolgt, der unter Berücksichtigung der kürzesten und der längsten Verbindung zum Taktsignalanschluß errechnet wird, oder
- unter Berücksichtigung eines Mittelwertes erfolgt, der unter Berücksichtigung aller Verbindungen zum Taktsignalanschluß errechnet wird, oder
- abwechselnd unter Berücksichtigung der kürzesten, der längsten oder einer anderen Verbindung erfolgt, oder
- unter Berücksichtigung einer zufällig ausgewählten Verbindung zum Taktsignalanschluß erfolgt.
wobei bei der Verwendung von Mittelwerten der jeweilige Mittelwert auf die nächste ganze Zahl auf- oder abgerundet sein kann.

Die Ermittlung der logischen Tiefe wird im folgenden anhand der Figur 1 erläutert. Die in der Figur 1 gezeigte Anordnung besteht aus NAND-Gattern N1 bis N10 und Invertern I1 bis I5, die wie in der Figur 1 gezeigt verschaltet sind. Die NAND-Gatter und Inverter sind Schaltungsteile, die sich, wie später noch genauer beschrieben wird, durch Ersatzinverter ersetzen lassen; die Anordnung ist eine nach der Durchführung des oben genannten ersten Schrittes erhaltene Anordnung.

Die Anordnung weist Eingangsanschlüsse IN1 bis IN4, einen Ausgangsanschluß O, und einen Taktsignaleingangsanschluß CLK auf, über welche der Anordnung ein Taktsignal zugeführt wird.

Den Schaltungsteilen, die sich durch einen Inverter ersetzen lassen, also den NAND-Gattern N1 bis N10 und den Invertern I1 bis I5 wird im vorstehend erwähnten zweiten Schritt eine logische Tiefe zugeordnet. Welche logische Tiefe den jeweiligen Schaltungsteilen zugeordnet wird, ist durch die in den Schaltungsteil-Symbolen stehenden Zahlen angegeben. Demnach ist den NAND-Gattern N1 bis N4 und N7 die logische Tiefe 0 zugeordnet, den NAND-Gattern N5, N6, N8, und N9 die logische Tiefe 1, den Invertern I1 bis I3 die logische Tiefe 2, dem NAND-Gatter N10 und dem Inverter I4 die logische Tiefe 3, und dem Inverter I5 die logische Tiefe 4.

Den NAND-Gattern N1 bis N4 ist die logische Tiefe 0 zugeordnet, weil jeweils einer der Eingangsanschlüsse derselben direkt mit dem Taktsignalanschluß CLK verbunden ist.

Dem NAND-Gatter N7 ist die logische Tiefe 0 zugeordnet, weil der Eingangsanschluß desselben, dem am wenigsten hintereinander angeordnete andere Gatter vorgeschaltet sind, über kein anderes Gatter, also direkt mit dem Taktsignalanschluß CLK verbunden ist. Daß gleichzeitig die anderen Eingangsanschlüsse des NAND-Gatters N7 über das NAND-Gatter N1 bzw. über die NAND-Gatter N1 und N5 bzw. über die NAND-Gatter N2 und N5 mit dem Taktsignalanschluß CLK verbunden sind, spielt keine Rolle, weil im betrachteten Beispiel nur die kürzesten Verbindungen zum Taktsignalanschluß CLK berücksichtigt werden.

Den NAND-Gattern N5 und N6 ist die logische Tiefe 1 zugeordnet, weil die Eingangsanschlüsse derselben über ein anderes Gatter, genauer gesagt über das NAND-Gatter N1 bzw. das NAND-Gatter N2 (Eingangsanschlüsse von N5) bzw. über das NAND-Gatter N2 bzw. das NAND-Gatter N3 (Eingangsanschlüsse von N6) mit dem Taktsignalanschluß CLK verbunden sind.

Dem Inverter I1 ist die logische Tiefe 2 zugeordnet, weil der Eingangsanschluß desselben über zwei hintereinander angeordnete andere Gatter, genauer gesagt über die NAND-Gatter N2 und N6 bzw. über die NAND-Gatter N3 und N6 mit dem Taktsignalanschluß CLK verbunden ist.

Dem NAND-Gatter N8 ist die logische Tiefe 1 zugeordnet, weil der Eingangsanschluß desselben, dem am wenigsten hintereinander angeordnete andere Gatter vorgeschaltet sind, über ein anderes Gatter, genauer gesagt über das Gatter N4 mit dem Taktsignalanschluß CLK verbunden ist.

Dem NAND-Gatter N9 ist die logische Tiefe 1 zugeordnet, weil der Eingangsanschluß desselben, dem am wenigsten hintereinander angeordnete andere Gatter vorgeschaltet sind, über ein anderes Gatter, genauer gesagt über das Gatter N7 mit dem Taktsignalanschluß CLK verbunden ist. Daß der betreffende Eingangsanschluß des NAND-Gatters N9 auch über die NAND-Gatter N1 und N7 sowie über die NAND-Gatter N1, N5 und N7, sowie über die Gatter N2, N5 und N7 mit dem Taktsignalanschluß CLK verbunden ist, bleibt außer Betracht, weil in betrachteten Beispiel nur jeweils die kürzesten (am wenigsten Gatter enthaltenden) Verbindungen zum Taktsignalanschluß CLK berücksichtigt werden.

Dem Inverter I2 ist die logische Tiefe 2 zugeordnet, weil der Eingangsanschluß desselben über zwei hintereinander angeordnete andere Gatter, genauer gesagt über die NAND-Gatter N4 und N8 mit dem Taktsignalanschluß CLK verbunden ist.

Dem Inverter I3 ist die logische Tiefe 2 zugeordnet, weil die kürzeste Verbindung zum Taktsignalanschluß CLK zwei hintereinander angeordnete andere Gatter, genauer gesagt die NAND-Gatter N7 und N9 enthält.

Dem Inverter I4 ist die logische Tiefe 3 zugeordnet, weil die kürzeste Verbindung zum Taktsignalanschluß CLK drei hintereinander angeordnete andere Gatter, genauer gesagt die NAND-Gatter N4 und N8 und den Inverter I2 enthält.

Dem NAND-Gatter N10 ist die logische Tiefe 3 zugeordnet, weil die kürzeste Verbindung zum Taktsignalanschluß CLK drei hintereinander angeordnete andere Gatter, genauer gesagt die NAND-Gatter N7 und N9 und den Inverter I3 enthält.

Dem Inverter I5 ist die logische Tiefe 4 zugeordnet, weil die kürzeste Verbindung zum Taktsignalanschluß CLK vier hintereinander angeordnete andere Gatter, genauer gesagt die NAND-Gatter N7, N9 und N10 und den Inverter I3 enthält.

Es wird nun davon ausgegangen, daß Schaltungsteile bzw. Gatter mit verschiedenen logischen Tiefen zu verschiedenen Zeitpunkten, genauer gesagt mit verschiedenen Verzögerungen zum Taktsignal schalten, und daß Schaltungsteile mit den selben logischen Tiefen gleichzeitig schalten.

Wie vorstehend bereits erwähnt wurde, werden im dritten Schritt von den Schaltungsteilen, die gleichzeitig ihr Ausgangssignal ändern oder ändern können, jeweils mehrere oder alle Schaltungsteile durch einen entsprechend großen einzigen Ersatzinverter ersetzt, wobei gleichzeitig schalten bedeutet, daß die gleichzeitig schaltenden Inverter mit der selben Verzögerung zum Taktsignal schalten. Demzufolge werden in diesem Schritt jeweils mehrere oder alle Schaltungsteile, denen die selbe logische Tiefe zugeordnet ist, durch einen entsprechend dimensionierten einzigen Ersatzinverter ersetzt.

Ein Beispiel einer daraus resultierenden Ersatzschaltung ist in Figur 2 gezeigt. Die in der Figur 2 gezeigte Ersatzschaltung besteht aus Verzögerungsgliedern V1 bis V4, Ersatzinvertern EI0 bis EI4, und Ersatzlasten EL0 bis EL4.

Der Ersatzinverter EI0 ersetzt die Schaltungsteile, welchen die logische Tiefe 0 zugeordnet ist; der Ersatzinverter EI1 ersetzt die Schaltungsteile, welchen die logische Tiefe 1 zugeordnet ist; der Ersatzinverter EI2 ersetzt die Schaltungsteile, welchen die logische Tiefe 2 zugeordnet ist; der Ersatzinverter EI3 ersetzt die Schaltungsteile, welchen die logische Tiefe 3 zugeordnet ist; der Ersatzinverter EI4 ersetzt die Schaltungsteile, welchen die logische Tiefe 4 zugeordnet ist.

Der Ersatzinverter EI0 erhält als Eingangssignal das der Anordnung gemäß Figur 1 über den Taktsignalanschluß CLK zugeführte Taktsignal. Dieses Taktsignal wird ferner dem ersten Verzögerungsglied V1 zugeführt. Das Verzögerungsglied V1 verzögert das Taktsignal um eine Gatterlaufzeit und gibt das daraus resultierende verzögerte Taktsignal an den Ersatzinverter EI1 und das Verzögerungsglied V2 aus. Das Verzögerungsglied V2 verzögert das ihm zugeführte Taktsignal um eine Gatterlaufzeit und gibt das daraus resultierende verzögerte Taktsignal an den Ersatzinverter EI2 und das Verzögerungsglied V3 aus. Das Verzögerungsglied V3 verzögert das ihm zugeführte Taktsignal um eine Gatterlaufzeit und gibt das daraus resultierende verzögerte Taktsignal an den Ersatzinverter EI3 und das Verzögerungsglied V4 aus. Das Verzögerungsglied V4 verzögert das ihm zugeführte Taktsignal um eine Gatterlaufzeit und gibt das daraus resultierende verzögerte Taktsignal an den Ersatzinverter EI4 aus.

Damit erhalten der Ersatzinverter EIO das unverzögerte Taktsignal als Eingangssignal, der Ersatzinverter EI1 das um eine Gatterlaufzeit verzögerte Taktsignal als Eingangssignal, der Ersatzinverter EI2 das um zwei Gatterlaufzeiten verzögerte Taktsignal als Eingangssignal, der Ersatzinverter EI3 das um drei Gatterlaufzeiten verzögerte Taktsignal als Eingangssignal, und der Ersatzinverter EI4 das um vier Gatterlaufzeiten verzögerte Taktsignal als Eingangssignal. Die Gatterlaufzeiten entsprechen der durchschnittlichen Signallaufzeit durch die Schaltungsteile und können für die Technologie, in welcher die digitale Schaltung realisiert werden soll, empirisch ermittelt (durch Messungen an einer in der selben Technologie realisierten anderen digitalen Schaltung) oder geschätzt werden.

Die Ausgangsanschlüsse der Ersatzinverter EI0 bis EI4 sind über die Ersatzlasten EL0 bis EL4 mit dem positiven oder dem negativen Pol der die Anordnung mit Energie versorgenden Versorgungsspannung verbunden.

Die Ersatzlasten sind im betrachteten Beispiel kapazitive, d.h. einen oder mehrere Kondensatoren enthaltende Lasten. Sie können jedoch zusätzlich oder alternativ auch ohmsche und induktive Komponenten enthalten.

Eine Ersatzlast entspricht jeweils der Summe der Lasten, die die durch den betreffenden Ersatzinverter ersetzten Gatter zu treiben haben. Die Ermittlung der Ersatzlast erfolgt im betrachteten Beispiel dadurch,
- daß die durchschnittliche Last ermittelt wird, die ein Gatter bei einem Schaltvorgang im allgemeinen zu treiben hat,
- daß die Anzahl der Gatter ermittelt wird, die von den die selbe logische Tiefe aufweisenden Gattern tatsächlich gleichzeitig schalten (von den die selbe logische Tiefe aufweisenden Gattern führt pro Takt des Taktsignals nur ein bestimmter Teil einen Schaltvorgang durch; der Rest behält sein Ausgangssignal unverändert bei), und
- daß die im ersten Schritt ermittelte durchschnittliche Last mit der im zweiten Schritt ermittelten Anzahl multipliziert wird.

Die durchschnittliche Last kann für die Technologie, in welcher die digitale Schaltung realisiert werden soll, empirisch (durch Messungen an einer in der selben Technologie realisierten anderen digitalen Schaltung) ermittelt oder geschätzt werden.

Die Ermittlung der Anzahl der Gatter, die von den die selbe logische Tiefe aufweisenden Gattern tatsächlich gleichzeitig schalten, erfolgt im betrachteten Beispiel durch eine Schätzung. Vorliegend wird davon ausgegangen, daß von den die selbe logische Tiefe aufweisenden Gattern in jeder Taktperiode
- ein Drittel vom hohen auf den niedrigen Pegel umschaltet,
- ein Drittel vom niedrigen auf den hohen Pegel umschaltet, und
- ein Drittel keinen Schaltvorgang durchführt.

Die Ermittlung der Anzahl der Gatter, die von den die selbe logische Tiefe aufweisenden Gattern tatsächlich gleichzeitig schalten, kann aber auch durch eine Simulation der Funktion der digitalen Schaltung erfolgen. Hierzu wird (beispielsweise unter Verwendung der Netzliste) untersucht, welche Gatter unter welchen Bedingungen umschalten. Eine solche Simulation ist, da hierfür keine backannotierte Netzliste verwendet werden muß, mit einem verhältnismäßig geringen Aufwand durchführbar. Durch eine solche Simulation kann exakt ermittelt werden, welche Anteile der die selbe logische Tiefe aufweisenden Gatter sich wie verhalten. Bei einer darauf basierenden Festlegung der Ersatzlasten, welche übrigens auch zeitlich variieren können, können die Ersatzlasten in sehr guter Übereinstimmung mit den tatsächlich auftretenden Lasten festgelegt werden.

Unabhängig hiervon kann vorgesehen werden, daß besonders hohe oder besonders niedrige Lasten treibende Schaltungsteile, beispielsweise Bustreiber oder lange Busleitungen gesondert behandelt werden.

Die Dimensionierung der Ersatzinverter erfolgt so, daß diese in der Lage sind, die jeweiligen Ersatzlasten zu treiben.

Durch die beschriebene Ersatzschaltung kann mit relativ hoher Genauigkeit ermittelt werden, welche Ströme die digitale Schaltung unter welchen Bedingungen zieht.

Um zu berücksichtigen, daß die durch einen Ersatzinverter ersetzten Gatter teils vom hohen Pegel auf den niedrigen Pegel umschalten, teils vom niedrigen auf den hohen Pegel umschalten, und teils überhaupt nicht schalten, werden die Ersatzinverter vorzugsweise jeweils durch mehrere Ersatzinverter realisiert. Im folgenden wird der Fall beschrieben, daß jeder der Ersatzinverter EI0 bis EI4 aus zwei Invertern besteht.

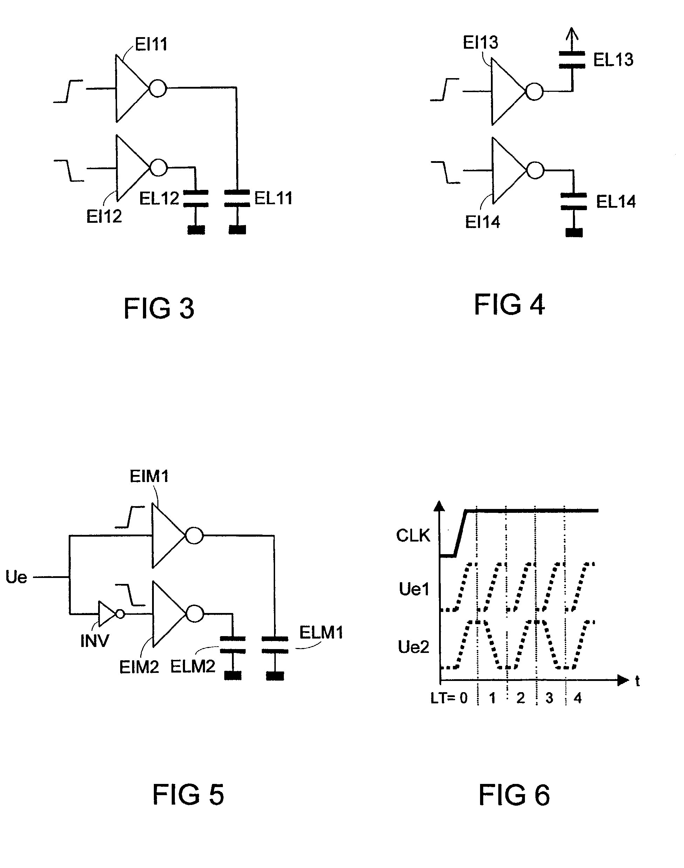

Die einen Ersatzinverter, beispielsweise den Ersatzinverter EI1 bildenden Inverter sind in Figur 3 gezeigt und mit den Bezugszeichen EI11 und EI12 bezeichnet.

Der Ersatzinverter EI11 ersetzt die Gatter, deren Ausgangssignal sich beim Umschalten vom Pegel 1 auf den Pegel 0 ändert, und der Ersatzinverter EI12 ersetzt die Gatter, deren Ausgangssignal sich beim Umschalten vom Pegel 0 auf den Pegel 1 ändert. Die Inverter treiben Ersatzlasten EL11 bzw. EL12, die mit Masse verbunden sind.

Eine mögliche Alternative zu den in der Figur 3 gezeigten Ersatzinvertern ist in Figur 4 gezeigt. Die dort gezeigten, mit den Bezugszeichen EI13 und EI14 bezeichneten Ersatzinverter können anstelle der in der Figur 3 gezeigten Ersatzinverter EI11 und EI12 verwendet werden.

Der Ersatzinverter EI13 entspricht dem Ersatzinverter EI11, und der Ersatzinverter EI14 entspricht dem Ersatzinverter EI12. Unterschiedlich ist aber die Verschaltung der Ersatzlast: während die Ersatzlasten bei den Ersatzinvertern EI11 und EI12 zwischen den Ausgangsanschlüssen der jeweiligen Ersatzinverter und dem negativen Pol der Versorgungsspannung (Masse) vorgesehen sind, ist die dem Ersatzinverter EI13 zugeordnete Ersatzlast mit dem positiven Pol der Versorgungsspannung verbunden, und die dem Ersatzinverter EI14 zugeordnete Ersatzlast mit dem negativen Pol der Versorgungsspannung verbunden.

Prinzipiell wäre es auch möglich, daß auch die Ersatzlast EL13 oder nur die Ersatzlast EL14 mit dem positiven Pol der Versorgungsspannung verbunden ist. Es wäre auch denkbar, daß die Ersatzinverter EI11 bis EI14 zumindest teilweise jeweils durch zwei Inverter ersetzt werden, von welchen einer eine mit dem positiven Pol der Versorgungsspannung verbundene Last treibt, und von welchen der andere eine mit dem negativen Pol der Versorgungsspannung verbundene Last treibt.

Eine Vereinfachung der Ersatzschaltung ergibt sich, wenn die für die verschiedenen logischen Tiefen vorgesehenen Ersatzinverter zusammengefaßt werden und durch ein modifiziertes (sich vom Taktsignal CLK unterscheidendes) Eingangssignal angesteuert werden. Damit können selbst die komplexesten digitale Schaltung durch wenige Ersatzinverter ersetzt werden.

Eine solche Ersatzschaltung ist in Figur 5 gezeigt. Die in der Figur 5 gezeigte Ersatzschaltung umfaßt den Ersatzinvertern EI11 und EI12 gemäß Figur 3 entsprechende Ersatzinverter EIM1 und EIM2, und einen dem Ersatzinverter EIM2 vorgeschalteten idealen Inverter INV. Der Ersatzschaltung wird ein Eingangssignal Ue zugeführt, das sich von dem Taktsignal CLK, welches der durch die Ersatzschaltung ersetzten digitalen Schaltung zugeführt wird, unterscheidet.

Mögliche Varianten des Eingangssignals Ue sind in Figur 6 dargestellt. Die Figur 6 zeigt
- das Taktsignal CLK, welches der durch die Ersatzschaltung ersetzten digitalen Schaltung zugeführt wird,
- eine erste, mit Ue1 bezeichnete Variante des bei der in der Figur 5 gezeigten Ersatzschaltung statt des Taktsignals CLK verwendbaren Eingangssignals Ue, und
- eine zweite, mit Ue2 bezeichnete Variante des bei der in der Figur 5 gezeigten Ersatzschaltung statt des Taktsignals CLK verwendbaren Eingangssignals Ue.

Das Signal Ue1 weist dort, wo das Taktsignal CLK eine Flanke aufweist, ebenfalls eine Flanke auf, und weist darüber hinaus nach 1, 2, 3, 4, ... Gatterlaufzeiten nochmals die selbe Flanke auf. Ue1 ist ein periodisches Signal mit einer einer Gatterlaufzeit entsprechenden Periodendauer.

Das Signal Ue2 weist dort, wo das Taktsignal CLK eine Flanke aufweist, ebenfalls eine Flanke auf, und weist darüber hinaus nach geradzahligen Anzahlen von Gatterlaufzeiten nochmals die selbe Flanke auf, nach ungeradzahligen Anzahlen von Gatterlaufzeiten eine entgegengesetzt verlaufende Flanke auf. Ue1 ist ein periodisches Signal mit einer zwei Gatterlaufzeiten entsprechenden Periodendauer.

Die Ersatzinverter EIM1 und EIM2 werden
- beim Auftreten der ersten Flanke im Eingangssignal Ue1 bzw. Ue2 als Ersatzinverter EI0 gemäß Figur 2 verwendet,
- beim Auftreten der eine Gatterlaufzeit später auftretenden nächsten Flanke im Eingangssignal Ue1 bzw. Ue2 als Ersatzinverter EI1 gemäß Figur 2 verwendet,
- beim Auftreten der eine Gatterlaufzeit später auftretenden nächsten Flanke im Eingangssignal Ue1 bzw. Ue2 als Ersatzinverter EI2 gemäß Figur 2 verwendet,
- beim Auftreten der eine Gatterlaufzeit später auftretenden nächsten Flanke im Eingangssignal Ue1 bzw. Ue2 als Ersatzinverter EI3 gemäß Figur 2 verwendet,
- beim Auftreten der eine Gatterlaufzeit später auftretenden nächsten Flanke im Eingangssignal Ue1 bzw. Ue2 als Ersatzinverter EI4 gemäß Figur 2 verwendet, usw.

Bei der Verwendung von Ue1 als Eingangssignal Ue wird der Inverter INV abwechselnd dem Ersatzinverter EIM1 und dem Ersatzinverter EIM2 vorgeschaltet; die Wechsel erfolgen jeweils zwischen zwei aufeinanderfolgenden Flanken in Ue1, genauer gesagt jeweils nach der Beendigung des durch die vorhergehende Flanke ausgelösten Schaltvorganges und vor dem Auftreten des den nächsten Schaltvorgang auslösenden folgenden Flanke (im betrachteten Beispiel zu den in der Figur 6 durch gestrichelte vertikale Linien gekennzeichneten Zeitpunkten).

Zu den genannten Zeitpunkten erfolgt auch eine Anpassung der Ersatzinverter EIM1 und EIM2 und der von diesen getriebenen Lasten. Diese Anpassung ist notwendig, weil die Ersatzinverter EI0 bis EI4 und die von diesen getriebenen Lasten, die durch die Ersatzinverter EIM1 und EIM2 und die von diesen getriebenen Lasten der Reihe nach gebildet werden, im allgemeinen unterschiedlich dimensioniert sind. Dies gilt sowohl bei Verwendung von Ue1 als Eingangssignal Ue, als auch bei Verwendung von Ue2 als Eingangssignal Ue.

Auf die vorstehend beschriebene Art und Weise, d.h. unter Verwendung einer Ersatzschaltung der vorstehend beschrieben Art läßt sich der von einer digitalen Schaltung gezogene Strom einfach, schnell und genau bestimmen.

### Bezugszeichenliste

- CLK: Taktsignalanschluß
- EIx: Ersatzinverter
- EIMx: Ersatzinverter
- ELx: Ersatzlast
- ELMx: Ersatzlast
- Ix: Inverter
- INx: Eingangsanschlüsse
- INV: Inverter
- Nx: NAND-Gatter
- O: Ausgangsanschluß
- Vx: Verzögerungsglieder
- Uex: Eingangssignal

## Patentansprüche

1. Verfahren, durch welches basierend auf dem Schaltplan einer digitalen Schaltung der im Betrieb der digitalen Schaltung von dieser gezogene Strom ermittelbar ist,
**dadurch gekennzeichnet,**
**daß** die Ermittlung des Stromes unter Verwendung einer Ersatzschaltung erfolgt, in welcher Schaltungsteile der digitalen Schaltung, deren Ausgangssignalpegel sich gleichzeitig ändern oder ändern können, durch einen Inverter ersetzt sind.

2. Verfahren nach Anspruch 1,
**dadurch gekennzeichnet,**
**daß** zur Generierung der verwendeten Ersatzschaltung
- in einem ersten Schritt die digitale Schaltung in jeweils mehrere Bauteile umfassende Schaltungsteile partitioniert wird,
- in einem zweiten Schritt ermittelt wird, welche der im ersten Schritt ermittelten Schaltungsteile ihren Ausgangssignalpegel gleichzeitig ändern oder ändern können, und
- in einem dritten Schritt mehrere oder alle Schaltungsteile, die ihren Ausgangssignalpegel gleichzeitig ändern oder ändern können, durch einen einzigen Inverter ersetzt werden.

3. Verfahren nach Anspruch 1 oder 2,
**dadurch gekennzeichnet,**
**daß** die Schaltungsteile, die in der verwendeten Ersatzschaltung durch einen Inverter ersetzt werden, einen oder mehrere Eingangsanschlüsse und einen Ausgangsanschluß aufweisen.

4. Verfahren nach einem der vorhergehenden Ansprüche,
**dadurch gekennzeichnet,**
**daß** die Schaltungsteile, die in der verwendeten Ersatzschaltung durch einen Inverter ersetzt werden, logische Gatter repräsentierende Schaltungsteile sind.

5. Verfahren nach einem der vorhergehenden Ansprüche,
**dadurch gekennzeichnet,**
**daß** in der verwendeten Ersatzschaltung alle Schaltungsteile, deren Ausgangssignalpegel sich gleichzeitig vom niedrigen auf den hohen Pegel ändert oder ändern kann, durch einen einzigen Inverter ersetzt sind.

6. Verfahren nach einem der vorhergehenden Ansprüche,
**dadurch gekennzeichnet,**
**daß** in der verwendeten Ersatzschaltung alle Schaltungsteile, deren Ausgangssignalpegel sich gleichzeitig vom hohen auf den niedrigen Pegel ändert oder ändern kann, durch einen einzigen Inverter ersetzt sind.

7. Verfahren nach einem der vorhergehenden Ansprüche,
**dadurch gekennzeichnet,**
**daß** die Inverter der verwendeten Ersatzschaltung und die von diesen getriebenen Lasten so dimensioniert sind, daß diese ungefähr von dem selben Strom durchflossen werden wie die dadurch ersetzten Schaltungsteile und die von diesen getriebenen Lasten.
